# EUROPEAN PATENT SPECIFICATION

(11) **EP 4 024 833 B1**
(45) Date of publication and mention of the grant of the patent: **01.11.2023**
(21) Application number: 21753232.4
(22) Date of filing: 08.02.2021
(51) Int. Cl.: H04M 1/02, H05K 5/06, H04R 1/08, H04M 1/03, H04R 1/04

(54) **ELECTRONIC DEVICE COMPRISING MICROPHONE MODULE**
ELEKTRONISCHE VORRICHTUNG MIT MIKROFONMODUL
DISPOSITIF ÉLECTRONIQUE COMPRENANT UN MODULE DE MICROPHONE

(30) Priority: 10.02.2020 KR 20200015484
(43) Date of publication of application: 06.07.2022
(73) Proprietor: Samsung Electronics Co., Ltd., Suwon-si, Gyeonggi-do 16677 (KR)
(72) Inventor: JUN, Sungsoo, Suwon-si, Gyeonggi-do 16677 (KR); PARK, Changho, Suwon-si, Gyeonggi-do 16677 (KR); YANG, Jaeyoung, Suwon-si, Gyeonggi-do 16677 (KR); KIM, Daekwang, Suwon-si, Gyeonggi-do 16677 (KR); CHUN, Sooung, Suwon-si, Gyeonggi-do 16677 (KR); KIM, Youngkyu, Suwon-si, Gyeonggi-do 16677 (KR); WEE, Jongchun, Suwon-si, Gyeonggi-do 16677 (KR); CHOI, Hwanseok, Suwon-si, Gyeonggi-do 16677 (KR); CHOI, Jongchul, Suwon-si, Gyeonggi-do 16677 (KR)
(74) Representative: Arnold & Siedsma
(86) International application number: PCT/KR2021/001640
(87) International publication number: WO 2021/162378

(56) References cited:
- WO-A1-2022/030885
- WO-A1-2022/154470
- KR-A- 20170 100 368
- KR-A- 20170 136 331
- KR-A- 20180 096 178
- KR-A- 20190 086 899
- US-A1- 2019 082 083
- US-A1- 2019 298 023
- US-B1- 10 148 800

## Description

### [Technical Field]

Embodiments of the disclosure described herein relate to an electronic device including a microphone module.

### [Background Art]

An electronic device may include a plurality of microphone modules therein to receive sounds in various directions. The electronic device may receive sounds in different directions with respect to the electronic device. The microphone modules may include a microphone capable of converting sound into an electrical signal.

Known from the art is the portable electronic devices disclosed in US 2019 0082083 A1, and having I/O assemblies that can include optical and audio components are described. An exemplary I/O assembly can include a first camera module and a second camera module that can be carried within a camera module housing. A flex connector can carry a strobe that can be positioned between the first camera module and the second camera module. A trim can enclose the first camera, the second camera and the strobe and optically isolates the optical components. An exemplary portable electronic device can include a side wall retainer that defines its perimeter, a front cover glass and a rear cover glass that cooperate to form an enclosure. The I/O assembly can be secured to the enclosure both from inside and outside of the rear cover glass. I/O assembly can also include an audio transducer that can record sound when the camera module are recording videos.

Also known from the art is the lens assembly disclosed in US 2019 298023 A1, for covering at least a portion of an electronic device having a camera and a microphone. The lens assembly includes a first optically transparent portion configured to cover the camera of the electronic device. The first optically transparent portion extends from a first front optically transparent region having an area bounded by a light-blocking material covering a portion of a front surface of the lens assembly to a first rear optically transparent region having an area bounded by a light-blocking material covering a portion of a rear surface of the lens assembly. The area of the first rear optically transparent region is larger than the area of the first front optically transparent region. The lens assembly further includes an acoustically transparent portion configured to cover the microphone of the electronic device. The acoustically transparent portion includes a water-resistant membrane.

Non-published state of the art further includes WO 2022030885 A1, published on 10 February 2022 and which discloses an electronic device according to one embodiment comprises: a housing; a camera decoration member of which at least a portion is arranged inside the housing, and which includes a first through hole allowing communication with the outside of the housing, the camera decoration member being formed to support a camera module arranged inside the housing; a microphone module arranged inside the housing so as to be adjacent to the camera module, the microphone module including a first circuit board arranged on the camera decoration member and a microphone arranged on the first circuit board; and a second circuit board which is arranged to face the camera decoration member with the microphone module therebetween and which includes a contact structure in contact with a portion of the first circuit board, wherein the contact structure is formed to electrically connect the first circuit board to the second circuit board and can be arranged between the first circuit board and the second circuit board to encompass the microphone.

Non-published state of the art further includes WO 2022 154470 A1, published on 21 June 2022, and which discloses an electronic apparatus that, according to an embodiment may comprise: a housing; a printed circuit board located inside the housing; a microphone substrate which is electrically connected to the printed circuit board and on which a microphone element and a flash element are arranged; a decoration member disposed facing the microphone substrate in a first direction and forming a portion of the surface of the housing, the decoration member having a second opening that is aligned with the flash element; and a flash window facing the decoration member, the flash window including a first portion that is accommodated in the second opening and aligned with the flash element in the first direction, and a second portion that extends from the first portion and passes between the decoration member and the microphone substrate. The electronic apparatus provides an audio input path for the microphone element, and the audio input path may include a gap formed between the first portion and the inner wall of the second opening.

### [Disclosure]

### [Technical Problem]

When a microphone module is disposed inside the electronic device, a microphone hole for receiving sound may be formed in a portion of a camera area. The electronic device may include a sound travel path extending from the microphone module to the microphone hole. The electronic device may include stacked structures, and when the sound travel path is elongated due to the stacked structures, sound may be lost between the stacked structures. Furthermore, due to an error in the assembly of the stacked structures, the center of the width of the sound travel path may not be constant, and therefore a flow of sound may be affected.

Embodiments of the disclosure provide an electronic device including a microphone module for simplifying stacked structures, providing a waterproof function, and improving sound quality.

### [Technical Solution]

At least some of the abovementioned problem(s) are at least partially addressed in an electronic device according to appended claim 1. Further preferred embodiments are provided in dependent claims 2-14.

### [Advantageous Effects]

The electronic device according to the embodiments of the disclosure may have a simplified structure by reducing stacked structures and may be advantageous for preventing a loss of sound introduced into the microphone module and improving sound quality. Furthermore, the electronic device may include the waterproof member and may prevent infiltration of water into the microphone module.

In addition, the disclosure may provide various effects that are directly or indirectly recognized.

### [Description of Drawings]

Fig. 1 is a block diagram illustrating an electronic device in a network environment according to various embodiments.
FIG. 2 is a front perspective view of an electronic device according to an embodiment.
FIG. 3 is a rear perspective view of the electronic device according to an embodiment.
FIG. 4 is an exploded perspective view of the electronic device according to an embodiment.
FIG. 5 is an exploded perspective view of a camera module and a structure of the electronic device according to an embodiment.
FIG. 6 is a plan view of a camera decoration member on which a microphone module of the electronic device is disposed according to an embodiment.
FIG. 7 is a view illustrating the camera decoration member and the microphone module of the electronic device according to an embodiment.
FIG. 8A is a sectional view of a portion of the camera decoration member on which the microphone module of the electronic device is disposed according to an embodiment.
FIG. 8B is a sectional view of a portion of the camera decoration member on which the microphone module of the electronic device is disposed according to an embodiment.
FIG. 9A is a view illustrating a coupling relationship between the microphone module and a second printed circuit board of the electronic device according to an embodiment.
FIG. 9B is a view illustrating a coupling relationship between the microphone module and the second printed circuit board of the electronic device according to an embodiment.
FIG. 10 is a sectional view of a portion of the camera decoration member on which the microphone module of the electronic device is disposed according to various embodiments.
FIG. 11 is a sectional view of a portion of the camera decoration member on which the microphone module of the electronic device is disposed according to various embodiments.

With regard to description of the drawings, identical or similar reference numerals may be used to refer to identical or similar components.

### [Mode for Invention]

Hereinafter, various embodiments of the disclosure may be described with reference to accompanying drawings. Accordingly, those of ordinary skill in the art will recognize that modification, equivalent, and/or alternative on the various embodiments described herein can be variously made without departing from the scope of the disclosure.

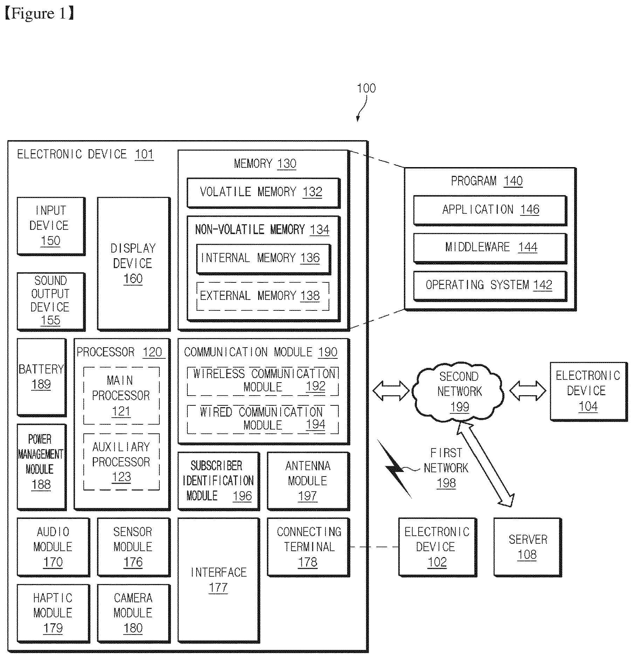

Fig. 1 is a block diagram illustrating an electronic device in a network environment according to various embodiments.

Referring to Fig. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module(SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

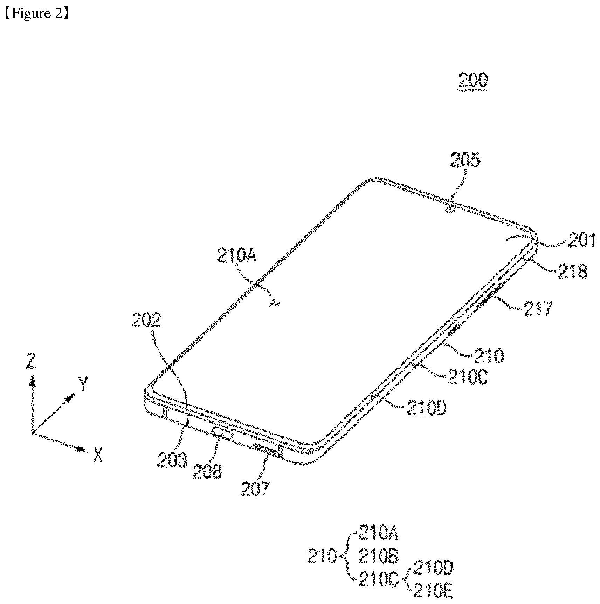

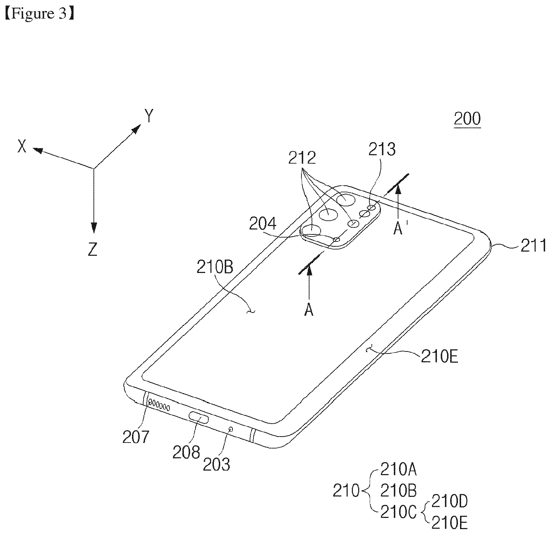

FIG. 2 is a front perspective view of an electronic device according to an embodiment. FIG. 3 is a rear perspective view of the electronic device according to an embodiment.

Referring to FIGS. 2 and 3, the electronic device 200 according to an embodiment may include a housing 210 that includes a first surface (or, a front surface) 210A, a second surface (or, a rear surface) 210B, and a side surface 210C surrounding a space between the first surface 210A and the second surface 210B.

In another embodiment (not illustrated), the housing 210 may refer to a structure that forms some of the first surface 210A, the second surface 210B, and the side surface 210C of FIG. 1.

According to an embodiment, the first surface 210A may be formed by a front plate 202, at least a portion of which is substantially transparent (e.g., a glass plate including various coating layers, or a polymer plate). The second surface 210B may be formed by a back plate 211 that is substantially opaque. The back plate 211 may be formed of, for example, coated or colored glass, ceramic, a polymer, metal (e.g., aluminum, stainless steel (STS), or magnesium), or a combination of at least two of the aforementioned materials. The side surface 210C may be formed by a side bezel structure (or, a "frame structure") 218 that is coupled with the front plate 202 and the back plate 211 and that contains metal and/or a polymer.

In some embodiments, the back plate 211 and the side bezel structure 218 may be integrally formed with each other and may contain the same material (e.g., a metallic material such as aluminum).

In the illustrated embodiment, the front plate 202 may include, at opposite long edges thereof, two first areas 210D that curvedly and seamlessly extend from the first surface 210A toward the back plate 211.

In the illustrated embodiment, the back plate 211 may include, at opposite long edges thereof, two second areas 210E that curvedly and seamlessly extend from the second surface 210B toward the front plate 202.

In some embodiments, the front plate 202 (or, the back plate 211) may include only one of the first areas 210D (or, the second areas 210E). In another embodiment, the front plate 202 (or, the back plate 211) may not include a part of the first areas 210D (or, the second areas 210E).

In the embodiments, when viewed from a side of the electronic device 200, the side bezel structure 218 may have a first thickness (or, width) at sides (e.g., short sides) not including the first areas 210D or the second areas 210E and may have a second thickness at sides (e.g., long sides) including the first areas 210D or the second areas 210E, the second thickness being smaller than the first thickness.

According to an embodiment, the electronic device 200 may include at least one of a display 201, audio modules 203, 204, and 207 (e.g., the audio module 170 of FIG. 1), a sensor module (not illustrated) (e.g., the sensor module 176 of FIG. 1), camera modules 205 and 212 (e.g., the camera module 180 of FIG. 1), key input devices 217 (e.g., the input device 150 of FIG. 1), or a connector hole 208 (e.g., the connecting terminal 178 of FIG. 1). In some embodiments, the electronic device 200 may not include at least one component (e.g., the key input devices 217) among the aforementioned components, or may additionally include other component(s) (e.g., a light emitting element (not illustrated)).

The display 201, for example, may be exposed through most of the front plate 202. In some embodiments, at least a portion of the display 201 may be exposed through the front plate 202 that includes the first surface 210A and the first areas 210D of the side surface 210C.

In some embodiments, the periphery of the display 201 may be formed to be substantially the same as the shape of the adjacent outside edge of the front plate 202. In another embodiment (not illustrated), to expand the area by which the display 201 is exposed, the gap between the outside edge of the display 201 and the outside edge of the front plate 202 may be formed to be substantially constant.

In an embodiment, a surface of the housing 210 (or, the front plate 202) may include a screen display area that is formed as the display 201 is visually exposed. For example, the screen display area may include the first surface 210A and the first areas 210D of the side surface.

In some embodiments, the screen display area 210A and 210D may include a sensing area (not illustrated) that is configured to obtain biometric information of a user. Here, when the screen display area 210A and 210D includes the sensing area, this may mean that at least a portion of the sensing area overlaps the screen display area 210A and 210D. For example, the sensing area may refer to an area capable of displaying visual information by the display 201 like the other areas of the screen display area 210A and 210D and additionally obtaining the user's biometric information (e.g., fingerprint).

In an embodiment, the screen display area 210A and 210D of the display 201 may include an area through which the first camera module 205 (e.g., a punch hole camera) is visually exposed. For example, the area through which the first camera module 205 is exposed may be surrounded by the screen display area 210A and 210D. In various embodiments, the first camera module 205 may include a plurality of camera modules (e.g., the camera module 180 of FIG. 1).

In another embodiment (not illustrated), the display 201 may be coupled with, or disposed adjacent to, touch detection circuitry, a pressure sensor capable of measuring the intensity (pressure) of a touch, and/or a digitizer that detects a stylus pen of a magnetic field type.

In some embodiments, at least some of the key input devices 217 may be disposed on the side surface 210C (e.g., the first areas 210D and/or the second areas 210E).

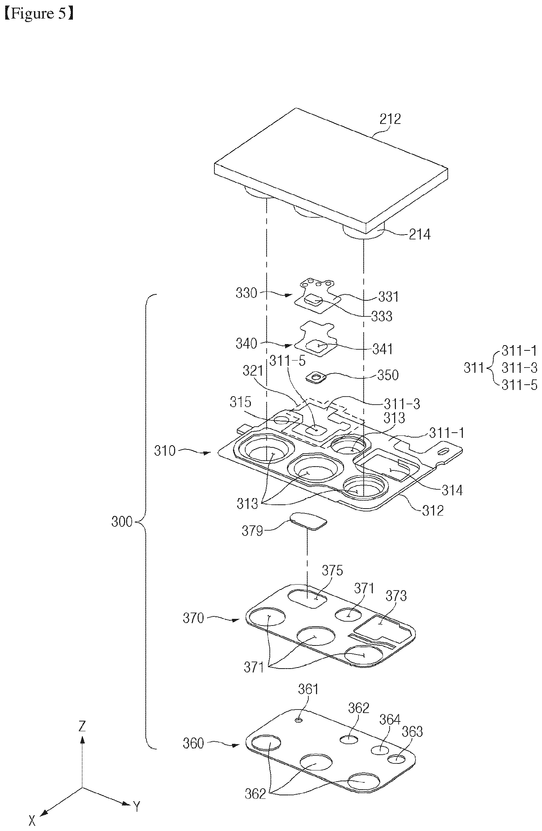

The audio modules 203, 204, and 207 may include the microphone holes 203 and 204 and the speaker hole 207. A microphone for obtaining external sound may be disposed in the microphone holes 203 and 204, and in some embodiments, a plurality of microphones may be disposed in the microphone holes 203 and 204 to detect the direction of sound. In some embodiments, the microphone hole 204 formed in a partial area of the second surface 210B (e.g., a microphone hole 361 of FIG. 5) may be disposed adjacent to the camera modules 205, 212, and 213. For example, the microphone hole 204 may obtain sounds when the camera modules 205, 212, and 213 are executed, or may obtain sounds when other functions are executed. The speaker hole 207 may include an external speaker hole 207 and a receiver hole for telephone call (not illustrated). In some embodiments, the speaker hole 207 and the microphone holes 203 and 204 may be implemented with a single hole, or a speaker (e.g., a piezoelectric speaker) may be included without the speaker hole 207.

The sensor module (not illustrated) (e.g., the sensor module 176 of FIG. 1) may generate an electrical signal or a data value that corresponds to an operational state inside the electronic device 200 or an environmental state external to the electronic device 200. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biosensor, a temperature sensor, a humidity sensor, or an illuminance sensor.

The camera modules 205, 212, and 213 may include the first camera module 205 (e.g., a punch hole camera) exposed on the first surface 210A of the electronic device 200, and the second camera module 212 and/or the flash 213 exposed on the second surface 210B of the electronic device 200.

In an embodiment, the first camera module 205 may be exposed through a portion of the screen display area 210A and 210D of the display 201. For example, the first camera module 205 may be exposed on a partial area of the screen display area 201A and 210D through an opening (not illustrated) that is formed in a portion of the display 201.

In an embodiment, the second camera module 212 may include a plurality of camera modules (e.g., a dual camera, a triple camera, or a quad camera). However, the second camera module 212 is not necessarily limited to including the plurality of camera modules and may include one camera module.

The first camera module 205 and the second camera module 212 may include one or more lenses, an image sensor, and/or an image signal processor. The flash 213 may include, for example, a light emitting diode or a xenon lamp. In some embodiments, two or more lenses (an IR camera lens, a wide angle lens, and a telephoto lens) and image sensors may be disposed on one surface of the electronic device 200.

The key input devices 217 may be disposed on the side surface 210C of the housing 210. In another embodiment, the electronic device 200 may not include all or some of the aforementioned key input devices 217, and the key input devices 217 not included may be implemented in a different form, such as a soft key, on the display 201. In some embodiments, the key input devices may include a sensor module (not illustrated) that forms the sensing area (not illustrated) that is included in the screen display area 210A and 210D.

The connector hole 208 may include the first connector hole 208 in which a connector (e.g., a USB connector) for transmitting and receiving power and/or data with an external electronic device is accommodated, and/or a second connector hole (not illustrated) (e.g., an earphone jack) in which a connector for transmitting and receiving audio signals with an external electronic device is accommodated.

In various embodiments, the electronic device 200 may include a light emitting element (not illustrated). The light emitting element, for example, may be disposed on the first surface 210A of the housing 210. The light emitting element, for example, may provide state information of the electronic device 200 in the form of light. In another embodiment, the light emitting element may provide, for example, a light source that operates in conjunction with an operation of the first camera module 205. The light emitting element may include, for example, an LED, an IR LED, and/or a xenon lamp.

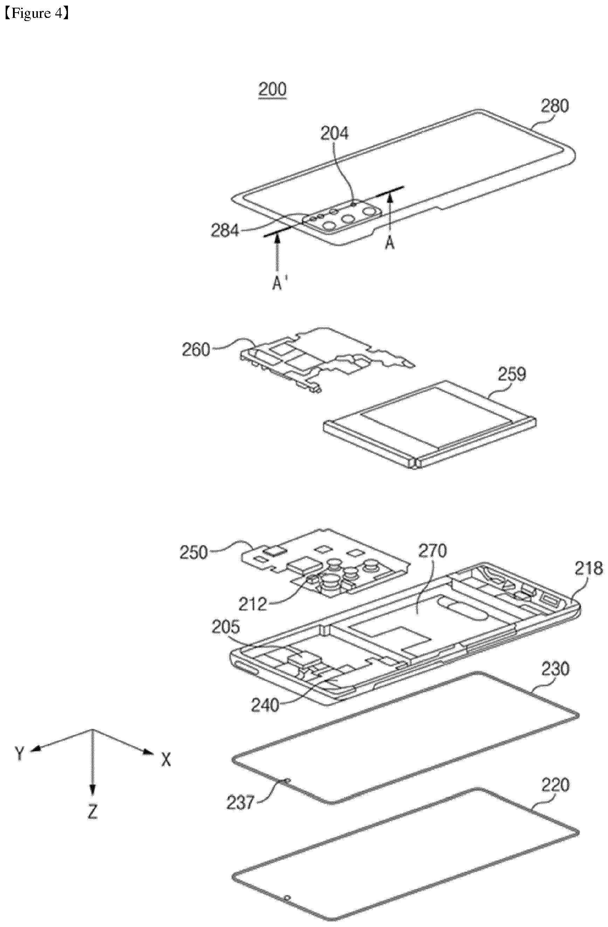

FIG. 4 is an exploded perspective view of the electronic device according to an embodiment.

Referring to FIG. 4, the electronic device 200 may include a front plate 220 (e.g., the front surface 210A and the first areas 210D of FIG. 2), a display 230 (e.g., the display 201 of FIG. 2), the side bezel structure 218 (e.g., a portion of the side surface 210C of FIG. 3A), a first support member 240 (e.g., a plate structure), a printed circuit board 250, a battery 259, a second support member 260 (e.g., a rear case), an antenna 270, and a back plate 280 (e.g., the rear surface 210B and the second areas 210E of FIG. 3).

In some embodiments, the electronic device 200 may not include at least one component (e.g., the first support member 240 or the second support member 260) among the aforementioned components, or may additionally include other component(s). At least one of the components of the electronic device 200 may be identical or similar to at least one of the components of the electronic device 200 of FIG. 2 or FIG. 3, and repetitive descriptions will hereinafter be omitted.

The first support member 240 may be disposed inside the electronic device 200 and may be connected with the side bezel structure 218, or may be integrally formed with the side bezel structure 218. The first support member 240 may be formed of, for example, a metallic material and/or a nonmetallic (e.g., polymer) material. The display 230 may be coupled to one surface of the first support member 240, and the printed circuit board 250 may be coupled to an opposite surface of the first support member 240. The printed circuit board 250 may have a processor, memory, and/or an interface mounted thereon. The processor may include, for example, one or more of a central processing unit, an application processor, a graphic processing unit, an image signal processor, a sensor hub processor, or a communication processor.

The memory may include, for example, volatile memory or nonvolatile memory.

The interface may include, for example, a high definition multimedia interface (HDMI), a universal serial bus (USB) interface, an SD card interface, and/or an audio interface. For example, the interface may electrically or physically connect the electronic device 200 with an external electronic device and may include a USB connector, an SD card/MMC connector, or an audio connector.

The battery 259, which is a device for supplying power to at least one component of the electronic device 200, may include, for example, a primary cell that is not rechargeable, a secondary cell that is rechargeable, or a fuel cell. At least a portion of the battery 259, for example, may be disposed on substantially the same plane as the printed circuit board 250. The battery 259 may be integrally disposed inside the electronic device 200, or may be disposed to be detachable from the electronic device 200.

The antenna 270 may be formed by a portion of the side bezel structure 218 and/or a portion of the first support member 240, or a combination thereof. The antenna 270 may include, for example, a near field communication (NFC) antenna, a wireless charging antenna, and/or a magnetic secure transmission (MST) antenna. For example, the antenna 270 may perform short-range communication with an external device, or may wirelessly transmit and receive power required for charging. In another embodiment (not illustrated), an antenna may be disposed between the back plate 280 and the battery 259.

In various embodiments, the first camera module 205 may be disposed on the first support member 240 of the side bezel structure 218 such that a lens is exposed through a partial area of the front plate 220 of the electronic device 200 (e.g., the front surface 210A of FIG. 2). For example, the first camera module 212 may be disposed such that the optical axis of the lens is at least partially aligned with a hole or recess 237 formed in the display 230. For example, the area through which the lens is exposed may be formed in the front plate 220. For example, the first camera module 205 may include a punch hole camera disposed in the hole or recess 237 formed in the rear surface of the display 230.

In various embodiments, the second camera module 212 may be disposed on the printed circuit board 250 such that a lens is exposed through a camera area 284 of the back plate 280 of the electronic device 200 (e.g., the rear surface 210B of FIG. 3) .

In the illustrated embodiment, the camera area 284 may be formed on a surface of the back plate 280 (e.g., the rear surface 210B of FIG. 3). In various embodiments, the camera area 284 may be formed to be at least partially transparent such that external light is incident on the lens of the second camera module 212. In the illustrated embodiment, at least a portion of the camera area 284 may protrude to a predetermined height from the surface of the back plate 280. However, without being limited thereto, the camera area 284 may form substantially the same plane as the surface of the back plate 280 in various embodiments.

In various embodiments, the electronic device 200 may include a structure (e.g., a structure 300 of FIG. 5) that forms the camera area 284.

Referring to FIG. 4, the camera area 284 is illustrated as being formed on a partial area of the back plate 280 through which the second camera module 212 is exposed. However, this corresponds to one embodiment, and the disclosure is not necessarily limited thereto. In various embodiments, the camera area 284 may be formed on a partial area of the front plate 220 through which the first camera module 205 is exposed. Alternatively, the camera area 284 may be formed on a portion of the side surface and/or the front surface of the housing (e.g., the housing 210 of FIGS. 2 and 3).

In various embodiments, the front plate 220, the back plate 280, and at least a portion of the side bezel structure 218 may form the housing (e.g., the housing 210 of FIGS. 2 and 3). In this case, the camera area 284 may be formed on at least a portion of a surface of the housing (e.g., the rear surface 210B of FIGS. 2 and 3), and the camera module 212 may be disposed inside the housing.

FIG. 5 is an exploded perspective view of a camera module and a structure of the electronic device according to an embodiment.

Referring to FIG. 5, the electronic device 200 may include the camera module 212 disposed inside the housing (e.g., the housing 210 of FIGS. 2 and 3) and the structure 300 that forms a camera area (e.g., the camera area 284 of FIG. 4).

In an embodiment, at least a portion of the camera module 212 may be disposed on a component (e.g., a camera decoration member 310) included in the structure 300. In various embodiments, at least portions of the camera module 212 may be accommodated in openings 313 and 314 formed in the camera decoration member 310.

In various embodiments, the camera module 212 may be seated on and/or coupled to the first support member of the electronic device 200 (e.g., the first support member 240 of FIG. 4). For example, the camera module 212 may be at least partially aligned with the structure 300 such that at least some of a plurality of cameras 214 are accommodated in the openings 313 and 314. For example, the camera module 212 may be aligned with the structure 300 in substantially the Z-axis direction.

In various embodiments, the camera module 212 may include the plurality of cameras 214. For example, the camera module 212 may include a wide angle camera module, a super-wide angle camera module, and/or a zoom camera module. In various embodiments, the camera module 212 may include a TOF sensor.

In various embodiments, the camera module 212 may include at least one actuator (not illustrated). For example, the actuator may include an actuator for an image stabilization function, an actuator for an auto focus function, and/or a shutter actuator.

In an embodiment, at least a portion of the structure 300 may be disposed inside the housing of the electronic device 200 (e.g., the housing 210 of FIGS. 2 and 3). In an embodiment, the structure 300 may include the camera decoration member 310, a microphone module 330, an adhesive member 340, a waterproof membrane 350, a camera window 360, a window tape 370, and/or a mesh member 379.

In an embodiment, the camera decoration member 310 may include one or more opening 313 and 314 formed therein in which at least portions of the camera module 212 are accommodated. For example, the camera module 212 may be disposed on the camera decoration member 310.

In various embodiments, the openings 313 and 314 may include the first openings 313 into which the cameras 214 of the camera module 212 are inserted and the second opening 314 into which a flash (e.g., the flash 213 of FIG. 2) or a TOF sensor module disposed in the housing 210 is inserted. In various embodiments, one or more first openings 313 may be formed to correspond to the number of cameras 214 included in the camera module 212. In the illustrated embodiment, the camera module 212 may be implemented with a quad camera, and four first openings 313 may be formed in the camera decoration member 310. However, without being necessarily limited thereto, the number of cameras included in the camera module 212 and the number of first openings 313 may be diversely modified in various embodiments.

In an embodiment, the camera decoration member 310 may include a first surface 311 facing toward the camera module 212 and a second surface 312 facing toward the camera window 360. For example, the first surface 311 may substantially face the +Z-axis direction, and the second surface 312 may substantially face the -Z-axis direction. For example, the first surface 311 may face toward the inner space of the housing (e.g., the housing 210 of FIGS. 2 and 3), and the second surface 312 may face toward the outside of the housing. For example, the first surface 311 may face toward the backplate (e.g., the back plate 280 of FIG. 4). In various embodiments, the camera decoration member 310 may be coupled with the camera module 212 such that the first surface 311 faces at least a portion of the camera module 212 (e.g., an area around the cameras 214).

In an embodiment, the microphone module 330 may be disposed on at least a partial area of the first surface 311 of the camera decoration member 310. For example, the first surface 311 may include a base area 311-1 and a microphone area 321 on which the microphone module 330 is disposed. For example, the first openings 313 and/or the second opening 314 may be formed in the base area 311-1. In various embodiments, the microphone area 321 may include an area recessed in the -Z-axis direction. For example, the microphone area 321 may be connected with the base area 311-1 in a stepped manner.

In an embodiment, the camera decoration member 310 may include a first through-hole 315. In an embodiment, the first through-hole 315 may be formed in at least a portion of the microphone area 321. In various embodiments, the first through-hole 315 may be at least partially aligned with a microphone 333 such that sound introduced from the outside reaches the microphone 333.

In various embodiments, the camera decoration member 310 may contain a metallic material. In various embodiments, the camera decoration member 310 may be construed as a camera enclosure in that the camera decoration member 310 functions to support the camera module 212.

In an embodiment, the microphone module 330 may include a first printed circuit board (PCB) 331 disposed on the camera decoration member 310 and the microphone 333 disposed on the first PCB 331.

In an embodiment, the first PCB 331 may be disposed on the first surface 311 of the camera decoration member 310. For example, the first PCB 331 may be disposed on the microphone area 321 of the camera decoration member 310. For example, the first PCB 331 may be attached to the microphone area 321 by the adhesive member 340. The first PCB 331 may be electrically connected with the microphone 333. In various embodiments, the first PCB 331 may be formed of a printed circuit board (PCB) or a flexible printed circuit board (FPCB).

In an embodiment, the microphone 333 may receive sound introduced from outside the housing 210 through the first through-hole 315. For example, the microphone 333 may convert the transferred sound into an electrical signal. In various embodiments, the microphone 333 may be disposed adjacent to the camera module 212. In an embodiment, the microphone 333 may be used to collect sounds related to a photographing operation of the camera module 212.

In an embodiment, the adhesive member 340 may attach the first PCB 331 to the camera decoration member 310. The adhesive member 340 may be disposed between the first PCB 331 and the camera decoration member 310. In various embodiments, the adhesive member 340 may be disposed on at least a portion of the microphone area 321. For example, the adhesive member 340 may be attached to a first area 311-3 in the +Z-axis direction, and the first PCB 331 may be attached in the +Z-axis direction to the adhesive member 340 attached to the first area 311-3.

In an embodiment, the adhesive member 340 may include a second through-hole 341 formed to be larger than the first through-hole 315. The waterproof membrane 350 may be disposed in the second through-hole 341. In an embodiment, the second through-hole 341 may be at least partially aligned with the first through-hole 315. For example, when viewed in the +Z-axis direction, the second through-hole 341 may at least partially overlap the first through-hole 315. In various embodiments, the adhesive member 340 may include a sheet and adhesive tapes formed on opposite surfaces of the sheet (e.g., a double-sided tape).

In an embodiment, the waterproof membrane 350 may be disposed between the camera decoration member 310 and the first PCB 331. In various embodiments, the waterproof member 350 may be disposed on at least a portion of the microphone area 321. In various embodiments, the waterproof membrane 350 may prevent infiltration of water into the microphone module 330. For example, the waterproof membrane 350 may be attached to a second area 311-5 in the +Z-axis direction. For example, the waterproof membrane 350 may be disposed in the inner space of the second through-hole 341 of the adhesive member 340 to cover the first through-hole 315. In various embodiments, the waterproof membrane 350 may be formed of a material through which water does not pass, but sound and/or air passes.

In an embodiment, the camera window 360 may be disposed on the second surface 312 (e.g., the lower surface) of the camera decoration member 310. In an embodiment, the camera window 360 may cover at least a portion of the camera module 212 disposed on the camera decoration member 310.

In an embodiment, the camera window 360 may include window areas 362, 363, and 364 that correspond to the first openings 313 or the second opening 314 formed in the camera decoration member 310. In an embodiment, the window areas 362, 363, and 364 may include the first transparent areas 362 at least partially aligned with the plurality of first openings 313, and the second transparent area 363 or the opaque area 364 at least partially aligned with the second opening 314. In various embodiments, the first transparent areas 362 and the second transparent area 363 may contain a material capable of transmitting light. In various embodiments, the opaque area 364 may at least partially contain a material that does not transmit light. In various embodiments, whether the opaque area 364 transmits light may be determined based on the wavelength range of light. For example, the opaque area 364 may be formed to pass only light corresponding to a specified wavelength range. For example, the opaque area 364 may be formed of a material that passes infrared rays (IR), but does not pass visible light. For example, the opaque area 364 may be formed in at least one of a transparent form, a translucent form, or an opaque form.

In various embodiments, the first transparent areas 362 may cover the cameras 214 disposed in the first openings 313. For example, when viewed in the -Z-axis direction, the first transparent areas 362 may at least partially overlap the cameras 214 disposed in the first openings 313. External light may be incident on the lenses of the cameras 214 through the first transparent areas 362. In various embodiments, the second transparent area 363 may cover the flash disposed in the second opening 314 (e.g., the flash 213 of FIG. 3). For example, when viewed in the -Z-axis direction, the second transparent area 363 may at least partially overlap the flash disposed in the second opening 314. Light emitted from the flash 213 may be irradiated outside the electronic device 200 through the second transparent area 363. In various embodiments, the TOF sensor module disposed in the second opening 314 may be aligned with the translucent area 364. For example, when viewed in the -Z-axis direction, the translucent area 364 may at least partially overlap the TOF sensor module disposed in the second opening 314.

In an embodiment, the camera window 360 may have, on a side thereof, the microphone hole 361 through which sound is introduced from outside the housing 210. In various embodiments, the microphone hole 361 may be formed to be fluidly connected with the first through-hole 315 of the camera decoration member 310. For example, sound introduced from outside the electronic device 200 may reach the microphone 333 through the microphone hole 361 and the first through-hole 315.

In an embodiment, the window tape 370 may be disposed between the camera window 360 and the camera decoration member 310. In an embodiment, the window tape 370 may attach the camera window 360 to the camera decoration member 310. In various embodiments, the window tape 370 may include an adhesive tape (e.g., a double-sided tape).

In various embodiments, the window tape 370 may have third openings 371 and a fourth opening 373 formed therein to correspond to the first openings 313 and the second opening 314 of the camera decoration member 310. For example, at least portions of the camera module 212 accommodated in the first openings 313 and the second opening 314 may be disposed in the third openings 371 and the fourth opening 373. In various embodiments, the window tape 370 may have a fifth opening 375 formed therein in which the mesh member 379 is disposed.

In an embodiment, the mesh member 379 may be disposed between the camera window 360 and the camera decoration member 310. In various embodiments, the mesh member 379 may be at least partially aligned with the microphone hole 361 of the camera window 360 and the first through-hole 315 of the camera decoration member 310. For example, when viewed in the -Z-axis direction, the mesh member 379 may at least partially overlap the microphone hole 361 of the camera window 360 and the first through-hole 315 of the camera decoration member 310. The mesh member 379 may be attached to the second surface 312 of the camera decoration member 310. In various embodiments, the mesh member 379 may at least partially include a metal mesh.

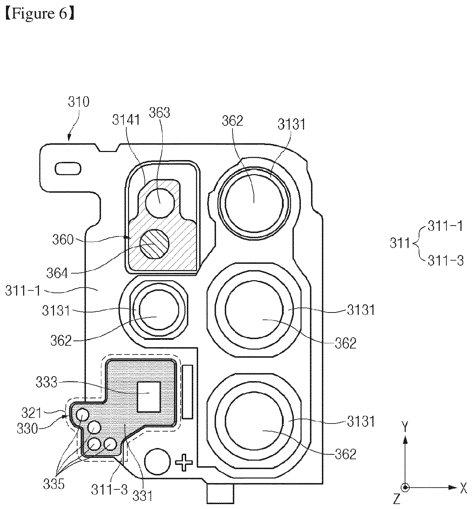

FIG. 6 is a plan view of the camera decoration member on which the microphone module of the electronic device is disposed according to an embodiment.

For example, FIG. 6 may be a view illustrating the first surface 311 of the camera decoration member 310 when viewed in the +Z-axis direction (e.g., from above) in the state in which the structure 300 illustrated in FIG. 5 is coupled.

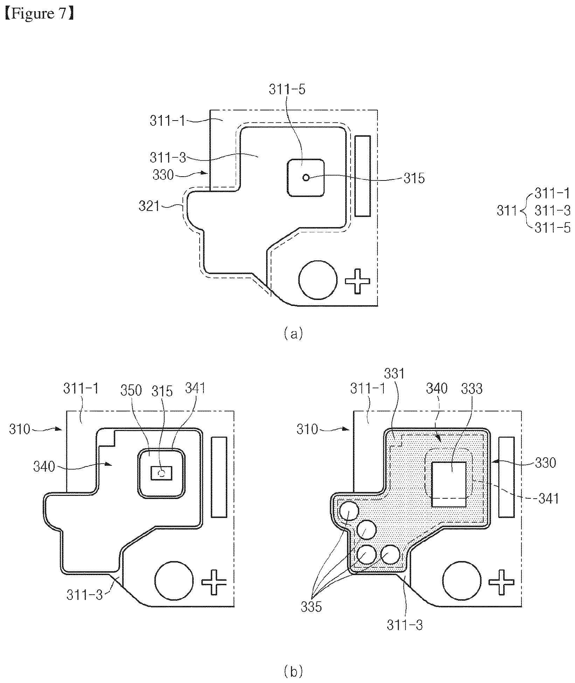

Referring to FIG. 6, the electronic device 200 may include the camera decoration member 310, the microphone module 330 disposed on the first surface 311 (or, the upper surface) of the camera decoration member 310, and/or the camera window 360 disposed on the second surface (or, the lower surface) of the camera decoration member 310 (e.g., the second surface 312 of FIG. 5). In various embodiments, at least a portion of the structure 300 may be disposed inside the housing 210 such that the first surface 311 of the camera decoration member 310 faces toward the inner space of the housing (e.g., the housing 210 of FIGS. 2 and 3) (e.g., refer to FIG. 7).

In an embodiment, the microphone module 330 may be disposed on the first surface 311 of the camera decoration member 310. For example, the camera decoration member 310 may have, on the first surface 311 thereof, the microphone area 321 on which the microphone module 330 is disposed. In various embodiments, the adhesive member 340 and/or the waterproof membrane 350 may be disposed on the microphone area 321. The microphone module 330 may be attached to the microphone area 321 through the adhesive member 340. Referring to FIG. 6, the adhesive member 340 and the waterproof membrane 350 may be visually hidden by the microphone module 330 when the first surface 311 of the camera decoration member 310 is viewed in the +Z-axis direction.

In an embodiment, the first surface 311 of the camera decoration member 310 may include the base area 311-1 in which the first openings (e.g., the first openings 313 of FIG. 5) and the second opening (e.g., the second opening 314 of FIG. 5) are formed. For example, the base area 311-1 may include first peripheral portions 3131 that form the first openings 313 and/or a second peripheral portion 3141 that forms the second opening 314.

In various embodiments, the first peripheral portions 3131 may be connected with the base area 311-1 so as to be inclined. For example, the first peripheral portions 3131 may be formed to be inclined in the -Z-axis direction (e.g., the lower direction) from at least portions of the base area 311-1 (e.g., refer to FIG. 5). In various embodiments, the second peripheral portion 3141 may be connected with the base area 311-1 in a stepped manner. For example, the second peripheral portion 3141 may be formed in a stepped manner in the -Z-axis direction with respect to the base area 311-1 as at least a portion of the base area 311-1 is recessed in the -Z-axis direction.

In an embodiment, the microphone module 330 may include the first PCB 331 attached to the first surface 311 of the camera decoration member 310 and the microphone 333 disposed on the first PCB 331. For example, the microphone 333 may be disposed on at least a partial area of the first PCB 331 when the first surface 311 of the camera decoration member 310 is viewed from above (e.g., in the Z-axis direction). In various embodiments, the first PCB 331 may include a connecting area 335 electrically connected with a second printed circuit board (PCB) (e.g., the printed circuit board 250 of FIG. 3) disposed in the housing of the electronic device 200 (e.g., the housing 210 of FIGS. 2 and 3).

In an embodiment, the camera window 360 may be attached to the camera decoration member 310 using the window tape 370. For example, the window tape 370 may be formed in a shape substantially corresponding to the camera decoration member 310. For example, the third openings (e.g., the third openings 371 of FIG. 5) and the fourth opening (e.g., the fourth opening 373 of FIG.5) that have shapes substantially corresponding to the first openings 313 and the second opening 314 of the camera decoration member 310 may be formed in the window tape 370. In an embodiment, the window tape 370 may be substantially hidden by the camera decoration member 310 when the first surface 311 of the camera decoration member 310 is viewed from above (e.g., in the Z-axis direction).

In various embodiments, when the camera window 360 is attached to the camera decoration member 310, the first transparent areas 362 of the camera window 360 may be aligned with the first openings 313 of the camera decoration member 310 (e.g., the first openings 313 of FIG. 5), and the second transparent area 363 and the opaque area 364 of the camera window 360 may be aligned with the second opening 314 of the camera decoration member 310 (e.g., the second opening 314 of FIG. 5). For example, when the first surface 311 of the camera decoration member 310 is viewed from above, the first transparent areas 362 of the camera window 360 may be visually exposed through the first openings 313 as the first transparent areas 362 are disposed to at least partially overlap the first openings 313. For example, when the first surface 311 of the camera decoration member 310 is viewed from above, the second transparent area 363 and the opaque area 364 of the camera window 360 may be visually exposed through the second opening 314 as the second transparent area 363 and the opaque area 364 are disposed to at least partially overlap the second opening 314.

FIG. 7 is a view illustrating the camera decoration member and the microphone module of the electronic device according to an embodiment.

FIG. 7A is a view illustrating the microphone area formed on the camera decoration member. FIG. 7B is a view illustrating a state in which the adhesive member, the waterproof membrane, and the microphone module are disposed on the microphone area of the camera decoration member. For example, FIG. 7 may be a view illustrating the first surface of the camera decoration member when viewed from above.

Referring to FIG. 7, the electronic device 200 may include the camera decoration member 310 including the microphone area 321, and the microphone module 330, the adhesive member 340, and/or the waterproof membrane 350 disposed on at least a portion of the microphone area 321.

In an embodiment, the camera decoration member 310 may include the first surface 311 that includes the base area 311-1 and/or the microphone area 321. For example, the first surface 311 may be a surface that faces toward the inside of the electronic device 200.

In an embodiment, the first surface 311 of the camera decoration member 310 may include the base area 311-1 in which a plurality of openings (e.g., the openings 313 and 314 of FIG. 5) are formed and/or the microphone area 321 on which the microphone module 330 is disposed. In an embodiment, the microphone area 321 may include the first area 311-3 and/or the second area 311-5. In various embodiments, the first area 311-3 may be connected with the base area 311-1 in a stepped manner. In another example, the second area 311-5 may be connected with the first area 311-3 in a stepped manner. In various embodiments, the adhesive member 340 may be disposed on the first area 311-3. The waterproof membrane 350 may be disposed on the second area 311-5.

In various embodiments, the microphone area 321 may be formed in a shape corresponding to at least a portion (e.g., the first PCB 331) of the microphone module 330. The microphone module 330 may be attached to the microphone area 321 through various adhesive means (e.g., the adhesive member 340 of FIG. 5 and a double-sided tape).

In an embodiment, the camera decoration member 310 may include the first through-hole 315. In various embodiments, the first through-hole 315 may be formed through at least a portion of the second area 311-5. For example, the first through-hole 315 may be formed to be substantially located in the central portion of the second area 311-5.

In an embodiment, the adhesive member 340 may be attached to the first area 311-3. The second through-hole 341 may be formed through at least a partial area of the adhesive member 340. In various embodiments, the second through-hole 341 of the adhesive member 340 may be formed to be larger than the first through-hole 315 formed in the first area 311-3 of the camera decoration member 310. For example, when the adhesive member 340 is disposed on the first area 311-3, the first through-hole 315 may be located in the second through-hole 341. In an embodiment, the first through-hole 315 may be located substantially at the center of the second through-hole 341. However, this is illustrative, and the disclosure is not necessarily limited thereto. In various embodiments, the waterproof membrane 350 may be disposed in the second through-hole 341.

In an embodiment, the waterproof membrane 350 may be disposed on the second area 311-5. In an embodiment, the waterproof membrane 350 may be surrounded by the adhesive member 340. For example, the waterproof membrane 350 may be attached to the second area 311-5 in the state of being located in the second through-hole 341. In various embodiments, the waterproof membrane 350 may cover the first through-hole 315 formed in the second area 311-5. For example, when the first surface 311 of the camera decoration member 310 is viewed from above, the first through-hole 315 may be hidden by the waterproof membrane 350 attached to the second area 311-5. In an embodiment, the waterproof membrane 350 may prevent infiltration of water into the microphone module 330.

In various embodiments, the waterproof membrane 350 may be formed to correspond to the shape of the second through-hole 341. For example, when the second through-hole 341 is formed in a quadrilateral shape, the peripheral portion of the waterproof membrane 350 may be formed in a quadrilateral shape to correspond to the second through-hole 341. In the embodiment illustrated in FIG. 7, the waterproof membrane 350 and the second through-hole 341 may be formed in a quadrilateral shape having rounded corners. However, without being necessarily limited thereto, the shape of the waterproof membrane 350 and/or the second through-hole 341 may be diversely modified in various embodiments.

In an embodiment, the microphone module 330 may include the first PCB 331 attached to the adhesive member 340 and the microphone 333 disposed on the first PCB 331. In an embodiment, the first PCB 331 may be attached to the adhesive member 340 such that the microphone module 330 is disposed on the microphone area 321. For example, the first PCB 331 may be attached to the adhesive member 340 in the state in which the adhesive member 340 and the waterproof membrane 350 are disposed on the first area 311-3 and the second area 311-5 of the camera decoration member 310. For example, the adhesive member 340 and the waterproof membrane 350 may be disposed between the first surface 311 (e.g., the first area 311-3 and the second area 311-5) of the camera decoration member 310 and the first PCB 331. In various embodiments, the adhesive member 340 and the waterproof membrane 350 may at least partially overlap the microphone module 330 when the first surface 311 is viewed from above.

In an embodiment, the microphone 333 may be mounted and/or installed on the first PCB 331. In various embodiments, the microphone 333 may be aligned with the first through-hole 315 formed in the second area 311-5. In various embodiments, when the first surface 311 is viewed from above, the area where the microphone 333 is disposed may at least partially overlap the area where the adhesive member 340 is disposed. For example, the microphone 333 and the adhesive member 340 may be disposed on opposite surfaces of the first PCB 331, respectively. For example, the microphone 333 may be disposed on the upper surface of the first PCB 331, and the adhesive member 340 may be disposed on the lower surface of the first PCB 331. For example, the upper surface of the first PCB 331 may be defined as a surface visually exposed when the first surface 311 of the camera decoration member 310 is viewed from above, and the lower surface of the first PCB 331 may be defined as a surface that faces away from the upper surface and that is attached to the first surface 311 of the camera decoration member 310.

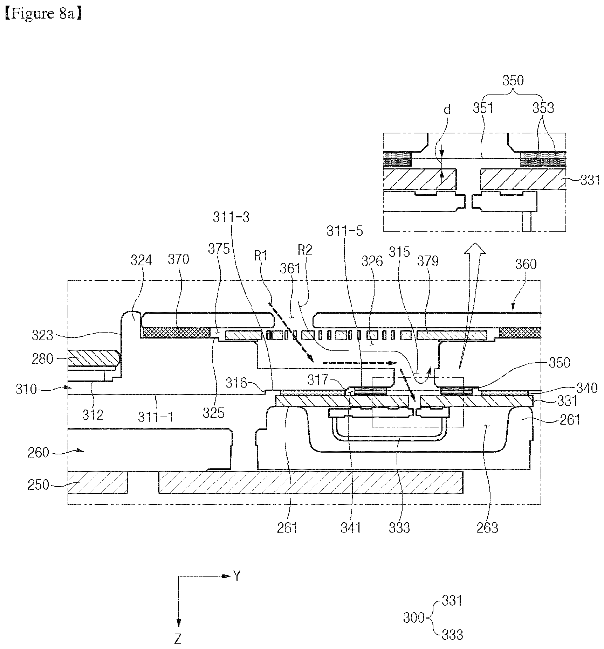

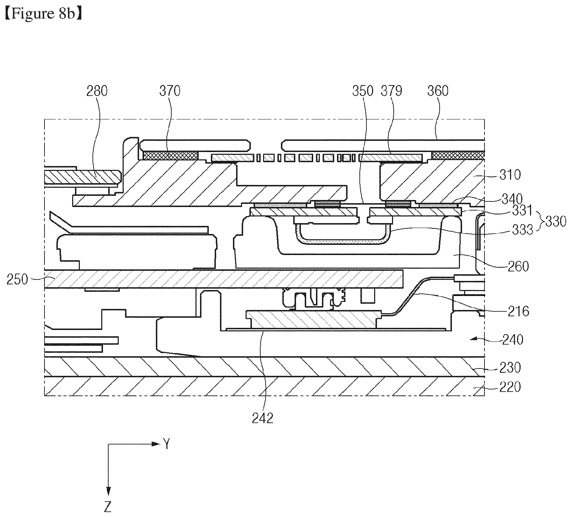

In various embodiments, the area where the microphone 333 is disposed on the upper surface may at least partially overlap the area where the adhesive member 340 is disposed on the lower surface (refer to FIGS. 8A and 8B). For example, the adhesive member 340 may be disposed to surround the periphery of the area where the microphone 333 is disposed on the first PCB 331, and thus sound introduced from outside the housing 210 may move to the microphone 333 without being lost in the space between the microphone module 330 and the camera decoration member 310.

FIG. 8A is a sectional view of a portion of the camera decoration member on which the microphone module of the electronic device is disposed according to an embodiment. FIG. 8B is a sectional view of a portion of the camera decoration member on which the microphone module of the electronic device is disposed according to an embodiment.

FIGS. 8A and 8B are sectional views taken along line A-A' illustrated in FIGS. 3 and 4.

Referring to FIG. 8A, the electronic device 200 may include the back plate 280, the camera decoration member 310, the microphone module 330, the adhesive member 340, the waterproof membrane 350, the camera window 360, the window tape 370, the mesh member 379, the second printed circuit board (PCB) 250, and/or the second support member 260.

In an embodiment, the back plate 280 may form at least a portion of the outer surface of the electronic device 200. For example, the back plate 280 may form the housing of the electronic device 200 (e.g., the housing 210 of FIGS. 2 and 5) together with at least a portion of the front plate (e.g., the front plate 220 of FIG. 4) and at least a portion of the side bezel structure (e.g., the side bezel structure 218 of FIG. 4). In various embodiments, the back plate 280 may have an opening area formed therein through which at least a portion of the camera decoration member 310 protrudes outside the back plate 280. In various embodiments, the back plate 280 may be attached with the camera decoration member 310 through an adhesive tape. For example, the back plate 280 may be attached with the second surface 312 of the camera decoration member 310.

In an embodiment, at least one portion of the camera decoration member 310 may be disposed inside the housing (e.g., the housing 210 of FIGS. 2 and 5), and another portion may be disposed outside the housing 210. In an embodiment, the camera decoration member 310 may include the first surface 311 facing toward the second PCB 250 or the second support member 260 and the second surface 312 facing away from the first surface 311. For example, the first surface 311 may refer to the surface facing the +Z-axis direction, and the second surface 312 may refer to the surface facing the -Z-axis direction.

In an embodiment, the microphone module 330, the adhesive member 340, and/or the waterproof membrane 350 may be disposed on the first surface 311. In another example, the camera window 360, the window tape 370, and/or the mesh member 379 may be disposed on the second surface 312. In various embodiments, at least a portion of the second surface 312 may protrude to a predetermined height with respect to the back plate 280. In various embodiments, the microphone module 330, the adhesive member 340, and/or the waterproof membrane 350 may be disposed in the +Z-axis direction with respect to the back plate 280. In various embodiments, the camera window 360, the window tape 370, and/or the mesh member 379 may be disposed in the -Z-axis direction with respect to the back plate 280.

In an embodiment, the first surface 311 of the camera decoration member 310 may include the base area 311-1, the first area 311-3 connected with the base area 311-1 in a stepped manner, and/or the second area 311-5 connected with the first area 311-3 in a stepped manner.

In various embodiments, the first area 311-3 may include an area that is recessed in the direction toward the second surface 312 (e.g., the -Z-axis direction), compared to the base area 311-1, and the second area 311-5 may include an area that is recessed in the direction toward the second surface 312, compared to the first area 311-3. For example, a first step 316 may be formed at the portion where the base area 311-1 and the first area 311-3 are connected. A second step 317 may be formed at the portion where the first area 311-3 and the second area 311-5 are connected. For example, the first area 311-3 may be connected with the base are 311-1 in a stepped manner in the -Z-axis direction by the first step 316. In another example, the second area 311-5 may be connected with the first area 311-3 in a stepped manner in the -Z-axis direction by the second step 317.

In an embodiment, the adhesive member 340 may be attached to the first area 311-3, and the waterproof membrane 350 may be attached to the second area 311-5. The first area 311-3 and the second area 311-5 may form the microphone area (e.g., the microphone area 321 of FIG. 7) on which the microphone module 330 is disposed. In various embodiments, the adhesive member 340 may be attached to the first area 311-3, the waterproof membrane 350 may be attached to the second area 311-5, and the microphone module 330 may be attached to the adhesive member 340.

In an embodiment, the camera decoration member 310 may include the first through-hole 315. In various embodiments, the first through-hole 315 may be formed in the second area 311-5. The first through-hole 315 may be at least partially fluidly connected with the outside of the electronic device 200 and may provide a passage through which sound introduced from outside the electronic device 200 moves to the microphone module 330.

In an embodiment, the camera decoration member 310 may include a protruding portion 323 that protrudes in the direction away from the second surface 312 with respect to the back plate 280. In various embodiments, the protruding portion 323 may extend from a partial area of the second surface 312. For example, the protruding portion 323 may protrude to a predetermined height in the -Z-axis direction with respect to the back plate 280.

In an embodiment, the protruding portion 323 may include a sidewall 324, a seating surface 325, and a third through-hole 326.

In an embodiment, the camera window 360 and/or the mesh member 379 may be disposed on the seating surface 325. In various embodiments, the camera window 360 may be attached to the seating surface 325 using the window tape 370. In an embodiment, the sidewall 324 may surround at least a portion of the periphery of the camera window 360 seated on the seating surface 325. For example, the sidewall 324 may further protrude beyond the seating surface 325 in the -Z-axis direction. In an embodiment, the third through-hole 326 may be formed in the seating surface 325 so as to be at least partially fluidly connected with the first through-hole 315 and/or the microphone hole 316. For example, the third through-hole 326 may be formed through at least a partial area of the seating surface 325. For example, the third through-hole 326 may be at least partially aligned with the mesh member 379 and the camera window 360 in the Z-axis direction.

According to the invention, the microphone module 330 includes the first PCB 331 attached to the first surface 311 of the camera decoration member 310 and the microphone 333 that is disposed on the first PCB 331 and that receives sound from the first through-hole 315. In an embodiment, the first PCB 331 may be attached to the first area 311-3 through the adhesive member 340. In an embodiment, the microphone 333 may be disposed to be electrically connected with the first PCB 331.

In various embodiments, the first PCB 331 and the microphone 333 may each have at least one hole formed therein through which sound is transferred from the first through-hole 315. In this case, the holes formed in the first PCB 331 and the microphone 333 may be fluidly connected with the first through-hole 315. In various embodiments, the holes formed in the first PCB 331 and the microphone 333 may be aligned with the first through-hole 315. For example, when viewed from above the first surface 311, the holes formed in the first PCB 331 and the microphone 333 may at least partially overlap the first through-hole 315.

The adhesive member 340 is disposed between the camera decoration member 310 and the first PCB 331. For example, the adhesive member 340 may be disposed between the first area 311-3 and the first PCB 331 such that the microphone module 330 is attached to the first area 311-3. The opposite surfaces of the adhesive member 340 may be attached to the first area 311-3 and the first PCB 331, respectively. In various embodiments, the adhesive member 340 may include a double-sided tape.

The adhesive member 340 has the second through-hole 341 formed therein. At least a portion of the second through-hole 341 may be fluidly connected with the first through-hole 315. In various embodiments, the second through-hole 341 may be formed to be larger than the first through-hole 315. In various embodiments, the second through-hole 341 may be aligned with the first through-hole 315 when the adhesive member 340 is attached to the first area 311-3. For example, when viewed from above the first surface 311, the second through-hole 341 may at least partially overlap the first through-hole 315.

In various embodiments, the adhesive member 340 may be attached with the first PCB 331 to surround the peripheral portion of the microphone 333. The adhesive member 340 may be compressed between the first PCB 331 and the first area 311-3 such that the first PCB 331 and the camera decoration member 310 are brought into close contact with each other. For example, the adhesive member 340 may strongly seal the separation space between the first PCB 331 and the camera decoration member 310. Accordingly, a phenomenon in which sound passing through the first through-hole 315 is lost toward the peripheral portion of the microphone 333 may be prevented, and sound may be more effectively transferred to the microphone 333.

According to the invention, the waterproof membrane 350 is disposed between the camera decoration member 310 and the first PCB 331. In various embodiments, the waterproof membrane 350 may prevent infiltration of water through the first through-hole 315 from outside the electronic device 200. In an embodiment, the waterproof membrane 350 may be attached to the second area 311-5 so as to be disposed between the second area 311-5 of the camera decoration member 310 and the first PCB 331. According to the invention, the waterproof membrane 350 is disposed in the second through-hole 341 to cover the first through-hole 315. Accordingly, the waterproof membrane 350 may block water such that the water does not pass through the first through-hole 315.

In an embodiment, the waterproof membrane 350 may be disposed to be spaced apart from the first PCB 331. For example, the first PCB 331 may be completely brought into close contact with the adhesive member 340 attached to the first area 311-3 and may be spaced apart from the waterproof membrane 350 attached to the second area 311-5 by a specified gap. For example, as the waterproof membrane 350 and the first PCB 331 are spaced apart from each other by the specified gap d, a space in which at least a portion of the waterproof membrane 350 is deformed substantially in the direction toward the first PCB 331 may be secured in the case where the pressure of water introduced from outside the electronic device 200 is applied to the waterproof membrane 350.

In an embodiment, the waterproof membrane 350 may include a waterproof layer 351 containing a waterproof material and/or an adhesive layer 353 that is disposed on at least a portion of the waterproof layer 351 and that attaches the waterproof layer 351 to the second area 311-5. In various embodiments, the adhesive member 353 may include an adhesive tape. In various embodiments, the waterproof layer 351 may at least partially contain a Gore-Tex material. However, without being limited thereto, in various embodiments, the waterproof layer 351 may be formed of various waterproof materials. In various embodiments, the adhesive member 340 and the waterproof membrane 350 may be located on substantially the same plane.

In an embodiment, the camera window 360 may be disposed on the second surface 312 of the camera decoration member 310. In various embodiments, the camera window 360 may be disposed on the protruding portion 323. For example, the camera window 360 may be disposed on the seating surface 325 such that the sidewall 324 surrounds the peripheral portion of the camera window 360. In various embodiments, the camera window 360 may be attached to the seating surface 325 through an adhesive tape.

In an embodiment, the camera window 360 may include the microphone hole 361. In an embodiment, the microphone hole 361 may be formed on a side of the camera window 360 so as to be at least partially fluidly connected with the first through-hole 315 and the second through-hole 341.

In an embodiment, the window tape 370 may be disposed between the camera window 360 and the seating surface 325. The window tape 370 may attach the camera window 360 to the seating surface 325. In an embodiment, the window tape 370 may have the fifth opening 375 formed therein. In various embodiments, the mesh member 379 may be disposed in the fifth opening 375.

In an embodiment, the mesh member 379 may be disposed between the camera window 360 and the seating surface 325. In various embodiments, the mesh member 379 may be attached to the seating surface 325 so as to be disposed in the fifth opening 375. In various embodiments, the mesh member 379 may be attached to the seating surface 325 through an adhesive tape. The mesh member 379 may prevent infiltration of foreign matter from outside the electronic device 200.

In an embodiment, the second PCB 250 may be disposed such that at least a portion thereof faces the first PCB 331. In various embodiments, the second PCB 250 or the first PCB 331 may be disposed inside the housing (e.g., the housing 210 of FIGS. 2 and 3). In various embodiments, the second PCB 250 may be electrically connected with the first PCB 331. For example, as the second PCB 250 and the first PCB 331 are electrically connected with each other, signals related to an operation of the microphone 333 may be transmitted and/or received between the second PCB 250 and the first PCB 331. For example, the second PCB 250 may be disposed further away from the back plate 280 in substantially the Z-axis direction than the first PCB 331.

In an embodiment, the second support member 260 may be disposed to at least partially face the first surface 311 of the camera decoration member 310. According to the invention, the second support member 260 is disposed inside the housing (e.g., the housing 210 of FIGS. 2 and 3). In various embodiments, the second support member 260 may be disposed between the camera decoration member 310 and the second PCB 250. At least a portion of the second support member 260 may be brought into contact with the camera decoration member 310 and/or the second PCB 250.

According to the invention, the second support member 260 supports at least a portion of the microphone module 330. According to the invention, the second support member 260 includes a receiving space 263 in which at least a portion of the microphone 333 is accommodated and/or a peripheral portion 261 protruding in the -Z-axis direction to form the receiving space 263. According to the invention, the peripheral portion 261 supports the first PCB 331 such that the first PCB 331 is stably attached to the camera decoration member 310. According to the invention, the peripheral portion 261 makes contact with at least a portion of the first PCB 331 to support the first PCB 331 in the Z-axis direction. The tfwmicrophone 333 is disposed in the receiving space 236.

According to an embodiment of the disclosure, the microphone hole 361 formed in the camera window 360 may be fluidly connected with the first through-hole 315 and the third through-hole 326 that are formed in the camera decoration member 310. Accordingly, sound introduced from outside the electronic device 200 may move to the microphone 333 through the microphone hole 361, the third through-hole 326, and the first through-hole 315 (e.g., R1 of FIG. 8A). In an embodiment, the adhesive member 340 attached between the first area 311-3 and the first PCB 331 may prevent the sound from being lost. In another example, the waterproof membrane 350 may prevent water introduced from outside the electronic device 200 from passing through the first through-hole 315 (e.g., R2 of FIG. 8A), thereby blocking infiltration of the water into the microphone 333.

According to an embodiment of the disclosure, the electronic device 200 may include the first PCB 331 formed separately from the second PCB 250, and the microphone 333 may be disposed on the first PCB 331.

For example, in the case where the microphone 333 is disposed on the second PCB 250 unlike in the embodiment of the disclosure, the distance between the microphone 333 and the microphone hole 361 may be increased. In this case, a plurality of structures (e.g., rubber) may be stacked between the microphone 333 and the microphone hole 361 to prevent a phenomenon in which sound is lost in an operation in which sound introduced through the microphone hole 361 reaches the microphone 333.

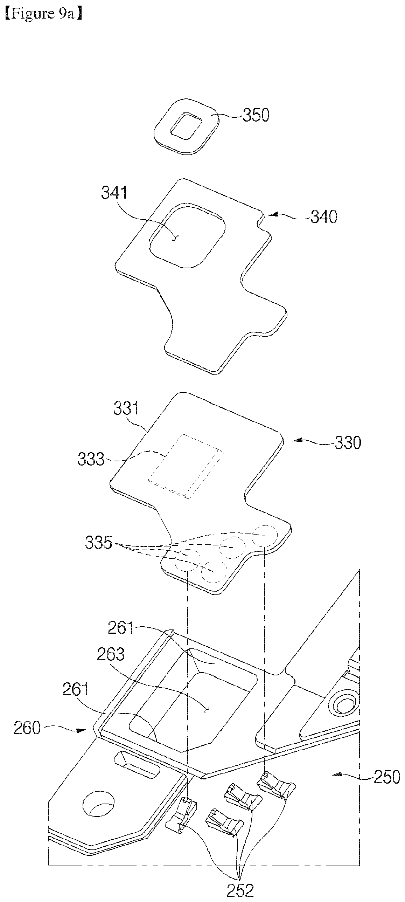

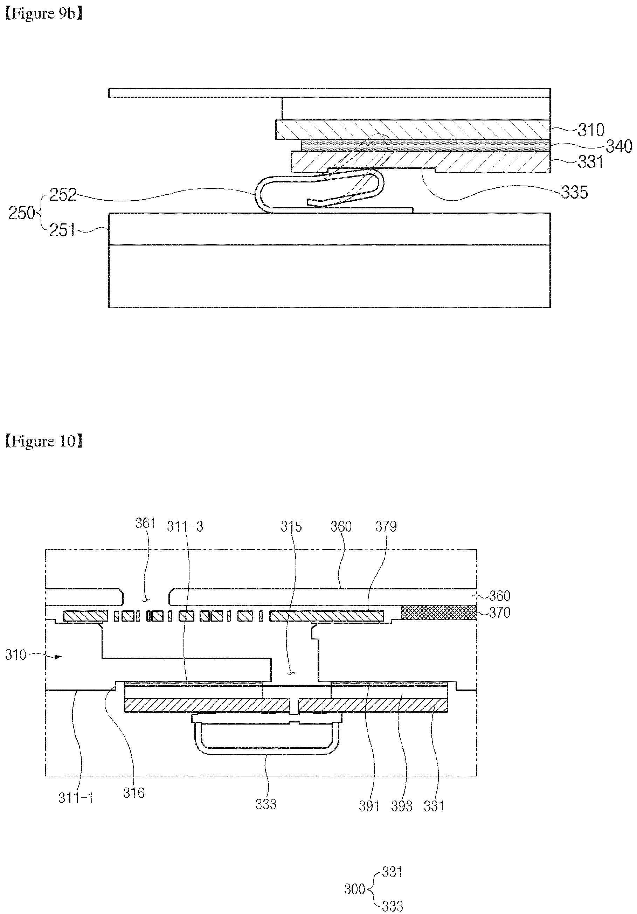

In contrast, the electronic device 200 according to the embodiment of the disclosure may include the first PCB 331 disposed adjacent to the microphone hole 361, and the first PCB 331 may be electrically connected with the second PCB 250 through a separate connecting member (e.g., connecting members 252 of FIG. 9). Due to this, the path along which sound introduced from outside the electronic device 200 moves from the microphone hole 361 to the microphone 333 may be shortened, and a stacked structure in which the adhesive member 340 and the waterproof membrane 350 are disposed on substantially the same plane may be implemented. Accordingly, the sound quality of the electronic device 200 may be improved, and it may be advantageous for uniformly maintaining the quality of the electronic device 200.

Referring to FIG. 8B, the electronic device 200 may further include the front plate 220 (e.g., the front plate 220 of FIG. 4), the display 230 (e.g., the display 230 of FIG. 4), and/or the first support member 240 (e.g., the first support member 240 of FIG. 4), in addition to the components illustrated in FIG. 8A (e.g., the back plate 280, the camera decoration member 310, the microphone module 330, the adhesive member 340, the waterproof membrane 350, the camera window 360, the window tape 370, the mesh member 379, the second PCB 250, and the second support member 260).

For example, FIG. 8B may be a view relating to an embodiment in which the first support member 240, the display 230, or the front plate 220 is additionally disposed in the direction away from the lower surface of the second PCB 250 (e.g., the Z-axis direction) in the embodiment of FIG. 8A. In describing FIG. 8B, repetitive descriptions identical to ones given with reference to FIG. 8A will be omitted.

In an embodiment, the front plate 220 may be disposed to face the back plate 280. For example, the front plate 220 may be disposed in substantially the Z-axis direction with respect to the back plate 280. In various embodiments, the front plate 220, together with the back plate 280, may form at least a portion of the outer surface of the electronic device 200. For example, the front plate 220 may form the front surface of the electronic device 200 (e.g., the front surface 210A of FIGS. 2 and 3), and the back plate 280 may form the rear surface of the electronic device 200 (e.g., the rear surface 210B of FIGS. 2 and 3).

In an embodiment, the display 230 may be disposed between the front plate 220 and the second PCB 250. In various embodiments, at least a portion of the display 230 may be brought into contact with the front plate 220. In various embodiments, the display 230 may be spaced apart from the second PCB 250 to form a space for the first support member 240 between the display 230 and the second PCB 250.

In an embodiment, at least a portion of the first support member 240 may be disposed between the display 230 and the second PCB 250. In various embodiments, the first support member 240 between the display 230 and the second PCB 250 may support at least a portion of the display 230 and/or at least a portion of the second PCB 250. In various embodiments, the first support member 240 may include a seating area 242 on which a camera module connector 216 is seated.

FIG. 9A is a view illustrating a coupling relationship between the microphone module and the second printed circuit board of the electronic device according to an embodiment. FIG. 9B is a view illustrating a coupling relationship between the microphone module and the second printed circuit board of the electronic device according to an embodiment.

Referring to FIGS. 9A and 9B, the electronic device 200 includes the microphone module 330, the adhesive member 340, the waterproof membrane 350, and may include the second PCB 250, and/or the second support member 260.

The microphone module 330 includes the first PCB 331 and the microphone 333 may be disposed on the lower surface of the first PCB 331. In this case, the lower surface of the first PCB 331 may be a surface facing toward the second PCB 250 or the second support member 260. In an embodiment, the adhesive member 340 may be attached to the upper surface of the first PCB 331.

In an embodiment, the first PCB 331 may include the connecting area 335 connected with the second PCB 250. In various embodiments, the connecting area 335 may be formed on the lower surface of the first PCB 331 to face toward the second PCB 250. In various embodiments, a plurality of connecting areas 335 may be formed to correspond to the connecting members 252. In various embodiments, the connecting areas 335 may at least partially contain a conductive material for electrical connection.

In an embodiment, the adhesive member 340 may be attached to the upper surface of the first PCB 331. In various embodiments, the adhesive member 340 may be disposed between the first PCB 331 and the camera decoration member 310. The adhesive member 340 includes the second through-hole 341. The waterproof membrane 350 is disposed in the second through-hole 341 of the adhesive member 340. In various embodiments, the waterproof membrane 350 may be attached to the second area (e.g., the second area 311-5 of FIG. 8A) of the camera decoration member 310 (e.g., the camera decoration member 310 of FIG. 8A) and may be spaced apart from the upper surface of the first PCB 331 by a specified gap (e.g., the gap d of FIG. 8A).

In an embodiment, the second PCB 250 may be disposed such that at least a portion thereof faces the first PCB 331. In an embodiment, the connecting members 252 may be disposed between the second PCB 250 and the first PCB 331.

In an embodiment, the connecting members 252 may electrically connect the second PCB 250 and the first PCB 331. In the illustrated embodiment, the connecting members 252 may be disposed on at least a portion of the second PCB 250. For example, the connecting members 252 may electrically connect the second PCB 250 and the first PCB 331 by making contact with the connecting areas 335 formed on the first PCB 331. In various embodiments, the connecting members 252 may at least partially contain a conductive material (e.g., metal).

In an embodiment, the connecting members 252 may be disposed on a plate 251 of the second PCB 250, and the connecting areas 335 may be formed on a portion of the first PCB 331. However, without being necessarily limited thereto, the positions of the connecting members 252 and the connecting areas 335 may be diversely modified. For example, the connecting members 252 may be disposed on the first PCB 331, and the connecting areas 335 may be formed on the second PCB 250.

In various embodiments, the connecting members 252 may contain an elastically deformable material such that the connecting members 252 are disposed on one of the first PCB 331 and the second PCB 250 to press the other one. For example, the connecting members 252 may include a C-clip or a pogo pin. In an embodiment, the connecting members 252 may be disposed on the second PCB 250. For example, when the second PCB 250 and the first PCB 331 are disposed to face each other, the connecting members 252 may press the connecting areas 335 of the first PCB 331 while being elastically deformed. For example, referring to FIG. 9B, the portion illustrated by the dotted line may correspond to the state before the elastic deformation of the connecting members 252, and the portion illustrated by the solid line may correspond to the state after the elastic deformation of the connecting members 252. For example, the connecting members 252 may return to the form before the elastic deformation while the first PCB 331 and the second PCB 250 in the assembled state are disassembled.

In an embodiment, the second support member 260 may be at least partially disposed between the microphone module 330 and the second PCB 250. In an embodiment, the second support member 260 may include the peripheral portion 261 supporting the first PCB 331 and the receiving space 263 formed by the peripheral portion 261. In various embodiments, when the first PCB 331 and the second PCB 250 are connected by the connecting members 252, the peripheral portion 261 may support at least a portion of the first PCB 331, and the receiving space 263 may accommodate the microphone 333 (e.g., refer to FIG. 8A). In various embodiments, the second support member 260 may not be included in the electronic device 200.

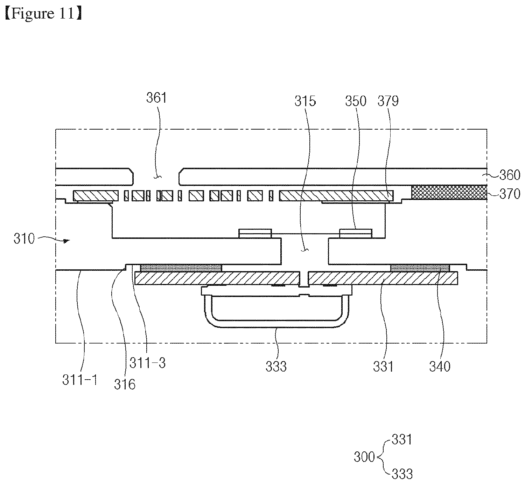

FIG. 10 is a sectional view of a portion of the camera decoration member on which the microphone module of the electronic device is disposed according to various embodiments. FIG. 11 is a sectional view of a portion of the camera decoration member on which the microphone module of the electronic device is disposed according to various embodiments.

FIGS. 10 and 11 may be views relating to embodiments in which the forms and/or positions of the adhesive member 340 and the waterproof membrane 350 are modified in the embodiment illustrated in FIGS. 8A and 8B.

In describing FIGS. 10 and 11, repetitive descriptions identical to ones given with reference to FIGS. 8A and 8B will be omitted.

In various embodiments, the adhesive member 340 and the waterproof membrane 350 of the electronic device 200 may be diversely modified.

Referring to FIG. 10, the electronic device 200 may include the camera decoration member 310 including the first surface (e.g., the base area 311-1 and the first area 311-3), the microphone module 330 including the first PCB 331 and the microphone 333, the camera window 360 including the microphone hole 361, the window tape 370 that attaches the camera window 360 to the camera decoration member 310, the mesh member 379 disposed between the camera window 360 and the camera decoration member 310, and/or a waterproof membrane 391 and an adhesive member 393 that are disposed between the first PCB 331 and the camera decoration member 310.

In an embodiment, the waterproof membrane 391 and the adhesive member 393 may be integrally formed with each other. For example, unlike in the embodiment illustrated in FIGS. 8A and 8B, the waterproof membrane 391 and the adhesive member 393 may be attached to each other. In various embodiments, one surface of the waterproof membrane 391 may be attached to the first area 311-3 of the camera decoration member 310. For example, the adhesive member 393 may be attached between an opposite surface of the waterproof membrane 391 that faces away from the one surface attached to the first area 311-3 and the first PCB 331.

In various embodiments, the first through-hole 315 may be formed in the first area 311-3, and the waterproof membrane 391 and the adhesive member 393 integrally formed with each other may be attached to the first area 311-3 to cover the first through-hole 315. In various embodiments, the first area 311-3 and the base area 311-1 may be connected by the first step 316 in a stepped manner.

Referring to FIG. 11, the electronic device 200 includes the camera decoration member 310, the microphone module and the adhesive member. The camera decoration member may include the first surface (e.g., the base area 311-1 and the first area 311-3). The microphone module 330 includes the first PCB 331 and the microphone 333. The electronic device may further include the camera window 360 including the microphone hole 361, the window tape 370 that attaches the camera window 360 to the camera decoration member 310, the mesh member 379 disposed between the camera window 360 and the camera decoration member 310. The electronic device further includes the adhesive member 340 disposed between the first PCB 331 and the camera decoration member 310. The electronic device may further include the waterproof membrane 350 disposed between the mesh member 379 and the camera decoration member 310.

In an embodiment, unlike in the embodiment illustrated in FIGS. 8A and 8B, the adhesive member 340 and the waterproof membrane 350 may not be disposed on substantially the same plane. In various embodiments, the adhesive member 340 may be disposed on the first area 311-3 of the camera decoration member 310, and the waterproof membrane 350 may be disposed on an area (e.g., the second surface 312 of FIG. 8A) that faces away from the first area 311-3. For example, the waterproof membrane 350 may be disposed on one surface closer to the camera window 360 based on the first through-hole 315. The adhesive member 340 may be disposed between the first area 311-3 and the first PCB 331.

In the various embodiments of the disclosure, the waterproof membrane 391 and the adhesive member 393 may be integrally formed with each other (e.g., refer to FIG. 10), or the waterproof membrane 350 may be disposed on the area facing away from the first area 311-3 on which the first PCB 331 is disposed (e.g., refer to FIG. 11). According to the various embodiments, as in the embodiment illustrated in FIGS. 8A and 8B, the stacked structure may be simply implemented, and a loss of sound may be effectively prevented so that the sound quality of the electronic device 200 may be improved.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a housing (210);
a camera decoration member (310) having at least a portion disposed inside the housing (210) and a first through-hole (315) formed therein to be at least partially fluidly connected with the outside of the housing (210), the camera decoration member being configured to support at least a portion of a camera module (212) disposed inside the housing (210);
a microphone module (330) including a first printed circuit board (331) disposed on the camera decoration member (310) and a microphone (333) disposed on the first printed circuit board;
an adhesive member (340) disposed between the first printed circuit board and the camera decoration member (310), the adhesive member having a second through-hole (341), at least a portion of which is fluidly connected with the first through-hole;
a waterproof membrane (350) disposed in the second through-hole and located between the camera decoration member (310) and the first printed circuit board (331) to cover the first through-hole; and
a support member (260) disposed inside the housing (210) and supporting the first printed circuit board (331) to be in contact with the camera decoration member, and
wherein the support member includes a receiving space (263) in which at least a portion of the microphone is accommodated and a peripheral portion (261) protruding to form the receiving space, and
wherein the peripheral portion contacts at least a portion of the first printed circuit board (331) to support the first printed circuit board (331).

2. The electronic device of claim 1, wherein the waterproof membrane is attached to the camera decoration member and disposed to be spaced apart from the first printed circuit board by a specified gap (d).

3. The electronic device of claim 1, wherein the waterproof membrane includes:
a waterproof layer (351) containing a waterproof material; and
an adhesive layer (353) disposed on at least a portion of the waterproof layer and configured to attach the waterproof layer to the camera decoration member.

4. The electronic device of claim 1, wherein the adhesive member and the waterproof membrane are configured to be located on the same plane.

5. The electronic device of claim 1, wherein the camera decoration member includes a first surface (311) on which the first printed circuit board is disposed and a second surface (312) configured to face away from the first surface, and
wherein the adhesive member and the waterproof membrane are disposed between a partial area of the first surface and the first printed circuit board.

6. The electronic device of claim 5, wherein the first surface of the camera decoration member includes a base area (311-1), a first area (311-3) on which the adhesive member is disposed, and a second area (311-5) on which the waterproof membrane is disposed.

7. The electronic device of claim 6, wherein the first area includes an area recessed in a direction toward the second surface, compared to the base area, and
wherein the second area includes an area recessed in the direction toward the second surface, compared to the first area.

8. The electronic device of claim 6, wherein the first through-hole is formed in the second area, and
wherein the waterproof membrane is configured to prevent infiltration of water through the first through-hole from outside the housing.

9. The electronic device of claim 6, wherein the base area has at least one opening (313, 314) formed therein in which at least a portion of the camera module is accommodated.

10. The electronic device of claim 1, wherein the second through-hole is arranged such that at least a portion thereof is fluidly connected with the first through-hole, and
wherein the microphone is disposed on the first printed circuit board and at least partially aligned with the first through-hole.

11. The electronic device of claim 5, further comprising:
a camera window (360) configured to at least partially cover the camera module,
wherein the camera window is disposed on the second surface of the camera decoration member.

12. The electronic device of claim 11, wherein the camera window has a microphone hole (361) formed therein through which sound is introduced from outside the housing, the microphone hole being at least partially fluidly connected with the first through-hole.

13. The electronic device of claim 12, wherein the camera decoration member includes a protruding portion (323) configured to extend from at least a partial area of the second surface toward the outside of the housing such that at least a portion of the camera decoration member protrudes to the outside of the housing, and
wherein the protruding portion has a third through-hole (326) formed therein to be fluidly connected with the microphone hole and the first through-hole.

14. The electronic device of claim 1, further comprising:
a second printed circuit board (250) disposed inside the housing and configured such that at least a portion overlaps the first printed circuit board when viewed from above the first printed circuit board; and
at least one connecting member (252) disposed between the second printed circuit board and the first printed circuit board,
wherein the connecting member electrically connects the second printed circuit board and the first printed circuit board.

## Patentansprüche

1. Elektronische Vorrichtung (200), die Folgendes umfasst:
ein Gehäuse (210);
ein Kameradekorationselement (310), das zumindest einen Abschnitt aufweist, der innerhalb des Gehäuses (210) angeordnet ist, und ein erstes Durchgangsloch (315), das darin ausgebildet ist, um zumindest teilweise mit der Außenseite des Gehäuses (210) in Fluidverbindung zu stehen, wobei das Kameradekorationselement so ausgelegt ist, dass es mindestens einen Abschnitt eines in dem Gehäuse (210) angeordneten Kameramoduls (212) trägt;
ein Mikrofonmodul (330) mit einer ersten Leiterplatte (331), die auf dem Kameradekorationselement (310) angeordnet ist, und einem Mikrofon (333), das auf der ersten Leiterplatte angeordnet ist;
ein Klebeelement (340), das zwischen der ersten Leiterplatte und dem Kameradekorationselement (310) angeordnet ist, wobei das Klebeelement ein zweites Durchgangsloch (341) aufweist, von dem mindestens ein Abschnitt mit dem ersten Durchgangsloch in Fluidverbindung steht;
eine wasserdichte Membran (350), die in dem zweiten Durchgangsloch angeordnet ist und sich zwischen dem Kameradekorationselement (310) und der ersten Leiterplatte (331) befindet, um das erste Durchgangsloch abzudecken; und
ein Stützelement (260), das innerhalb des Gehäuses (210) angeordnet ist und die erste Leiterplatte (331) so trägt, dass sie mit dem Kameradekorationselement in Kontakt steht, und
wobei das Stützelement einen Aufnahmeraum (263), in dem mindestens ein Abschnitt des Mikrofons untergebracht ist, und einen Umfangsabschnitt (261), der hervorsteht, um den Aufnahmeraum zu bilden, umfasst, und
wobei der periphere Abschnitt mindestens einen Abschnitt der ersten Leiterplatte (331) berührt, um die erste Leiterplatte (331) zu stützen.

2. Elektronische Vorrichtung nach Anspruch 1, wobei die wasserdichte Membran an dem Kameradekorationselement befestigt ist und so angeordnet ist, dass sie durch einen bestimmten Spalt (d) von der ersten Leiterplatte beabstandet ist.

3. Elektronische Vorrichtung nach Anspruch 1, wobei die wasserdichte Membran Folgendes enthält:
eine wasserdichte Schicht (351) mit einem wasserdichten Material; und
eine Klebeschicht (353), die auf mindestens einem Abschnitt der wasserdichten Schicht angeordnet ist und so ausgelegt ist, dass sie die wasserdichte Schicht an dem Kameradekorationselement befestigt.

4. Elektronische Vorrichtung nach Anspruch 1, wobei das Klebeelement und die wasserdichte Membran so ausgelegt sind, dass sie sich auf derselben Ebene befinden.

5. Elektronische Vorrichtung nach Anspruch 1, wobei das Kameradekorationselement eine erste Oberfläche (311) umfasst, auf der die erste Leiterplatte angeordnet ist, und eine zweite Oberfläche (312), die so ausgelegt ist, dass sie von der ersten Oberfläche abgewandt ist, und
wobei das Klebeelement und die wasserdichte Membran zwischen einem Teilbereich der ersten Oberfläche und der ersten Leiterplatte angeordnet sind.

6. Elektronische Vorrichtung nach Anspruch 5, wobei die erste Oberfläche des Kameradekorationselements einen Basisbereich (311-1), einen ersten Bereich (311-3), auf dem das Klebeelement angeordnet ist, und einen zweiten Bereich (311-5), auf dem die wasserdichte Membran angeordnet ist, umfasst.

7. Elektronische Vorrichtung nach Anspruch 6, wobei der erste Bereich einen Bereich umfasst, der im Vergleich zu dem Basisbereich in einer Richtung zu der zweiten Oberfläche hin vertieft ist, und wobei der zweite Bereich einen im Vergleich zu dem ersten Bereich in Richtung zu der zweiten Oberfläche vertieften Bereich umfasst.

8. Elektronische Vorrichtung nach Anspruch 6, wobei das erste Durchgangsloch in dem zweiten Bereich gebildet ist, und
wobei die wasserdichte Membran so ausgelegt ist, dass sie das Eindringen von Wasser durch das erste Durchgangsloch von außerhalb des Gehäuses verhindert.

9. Elektronische Vorrichtung nach Anspruch 6, wobei in dem Basisbereich mindestens eine Öffnung (313, 314) ausgebildet ist, in der mindestens ein Abschnitt des Kameramoduls untergebracht ist.

10. Elektronische Vorrichtung nach Anspruch 1, wobei das zweite Durchgangsloch so angeordnet ist, dass mindestens ein Abschnitt davon mit dem ersten Durchgangsloch in Fluidverbindung steht, und
wobei das Mikrofon auf der ersten Leiterplatte angeordnet ist und zumindest teilweise mit dem ersten Durchgangsloch ausgerichtet ist.

11. Elektronische Vorrichtung nach Anspruch 5, die ferner Folgendes umfasst:
ein Kamerafenster (360), das so ausgelegt ist, dass es das Kameramodul zumindest teilweise abdeckt,
wobei das Kamerafenster auf der zweiten Oberfläche des Kameradekorationselements angeordnet ist.

12. Elektronische Vorrichtung nach Anspruch 11, wobei in dem Kamerafenster ein Mikrofonloch (361) ausgebildet ist, durch das Schall von außerhalb des Gehäuses gelangt, wobei das Mikrofonloch zumindest mit dem ersten Durchgangsloch in Fluidverbindung ist.

13. Elektronische Vorrichtung nach Anspruch 12, wobei das Kameradekorationselement einen hervorstehenden Abschnitt (323) umfasst, der so ausgelegt ist, dass er sich von mindestens einem Teilbereich der zweiten Oberfläche zu der Außenseite des Gehäuses erstreckt, so dass mindestens ein Abschnitt des Kameradekorationselements zu der Außenseite des Gehäuses vorsteht, und wobei der vorstehende Abschnitt ein drittes Durchgangsloch (326) aufweist, das so darin ausgebildet ist, dass es mit dem Mikrofonloch und dem ersten Durchgangsloch in Fluidverbindung steht.

14. Elektronische Vorrichtung nach Anspruch 1, die ferner Folgendes umfasst:
eine zweite Leiterplatte (250), die im Inneren des Gehäuses angeordnet ist und so ausgelegt ist, dass bei Betrachtung von oben auf die erste Leiterplatte mindestens ein Abschnitt die erste Leiterplatte überlappt; und
mindestens ein Verbindungselement (252), das zwischen der zweiten Leiterplatte und der ersten Leiterplatte angeordnet ist,
wobei das Verbindungselement die zweite Leiterplatte und die erste Leiterplatte elektrisch verbindet.

## Revendications

1. Appareil électronique (200) comprenant :
un boîtier (210),
un élément décoratif de caméra (310) dont au moins une partie est disposée à l'intérieur du boîtier (210) et dans lequel est formé un premier trou traversant (315) lui permettant d'être au moins partiellement en communication fluidique avec l'extérieur du boîtier (210), l'élément décoratif de caméra étant conçu pour supporter au moins une partie d'un module de caméra (212) disposé à l'intérieur du boîtier (210),
un module de microphone (330) comprenant une première carte de circuit imprimé (331) disposée sur l'élément décoratif de caméra (310) et un microphone (333) disposé sur la première carte de circuit imprimé,
un élément adhésif (340) disposé entre la première carte de circuit imprimé et l'élément décoratif de caméra (310), l'élément adhésif ayant un deuxième trou traversant (341), dont au moins une partie est en communication fluidique avec le premier trou traversant,
une membrane étanche à l'eau (350) disposée dans le deuxième trou traversant et située entre l'élément décoratif de caméra (310) et la première carte de circuit imprimé (331) pour recouvrir le premier trou traversant, et
un élément de support (260) disposé à l'intérieur du boîtier (210) et supportant la première carte de circuit imprimé (331) de façon qu'elle soit en contact avec l'élément décoratif de caméra ;
ledit élément de support comprenant un espace de réception (263), dans lequel loge au moins une partie du microphone, et une partie périphérique (261) faisant saillie pour former l'espace de réception, et
ladite partie périphérique étant en contact avec au moins une partie de la première carte de circuit imprimé (331) pour supporter la première carte de circuit imprimé (331).

2. Appareil électronique selon la revendication 1, dans lequel la membrane étanche à l'eau est fixée à l'élément décoratif de caméra et disposée de manière à être espacée de la première carte de circuit imprimé selon un certain écart (d).

3. Appareil électronique selon la revendication 1, dans lequel la membrane étanche à l'eau comprend :
une couche étanche à l'eau (351) contenant un matériau imperméable, et
une couche adhésive (353) disposée sur au moins une partie de la couche étanche à l'eau et conçue pour fixer la couche étanche à l'eau à l'élément décoratif de caméra.

4. Appareil électronique selon la revendication 1, dans lequel l'élément adhésif et la membrane étanche à l'eau sont conçus pour être situés sur le même plan.

5. Appareil électronique selon la revendication 1, dans lequel l'élément décoratif de caméra comprend une première surface (311) sur laquelle est disposée la première carte de circuit imprimé et une deuxième surface (312) conçue pour être détournée de la première surface, et
dans lequel l'élément adhésif et la membrane étanche à l'eau sont disposés entre une zone partielle de la première surface et la première carte de circuit imprimé.

6. Appareil électronique selon la revendication 5, dans lequel la première surface de l'élément décoratif de caméra comprend une zone de base (311-1), une première zone (311-3) sur laquelle est disposé l'élément adhésif, et une deuxième zone (311-5) sur laquelle est disposée la membrane étanche à l'eau.

7. Appareil électronique selon la revendication 6, dans lequel la première zone comprend une zone en retrait en direction de la deuxième surface, par rapport à la zone de base, et
dans lequel la deuxième zone comprend une zone en retrait en direction de la deuxième surface, par rapport à la première zone.

8. Appareil électronique selon la revendication 6, dans lequel le premier trou traversant est formé dans la deuxième zone, et
dans lequel la membrane étanche à l'eau est conçue pour empêcher l'infiltration d'eau dans le premier trou traversant à partir de l'extérieur du boîtier.

9. Appareil électronique selon la revendication 6, dans lequel la zone de base comporte au moins une ouverture (313, 314) dans laquelle loge au moins une partie du module de caméra.

10. Appareil électronique selon la revendication 1, dans lequel le deuxième trou traversant est agencé de telle manière qu'au moins une partie de celui-ci est en communication fluidique avec le premier trou traversant, et
dans lequel le microphone est disposé sur la première carte de circuit imprimé et au moins partiellement aligné avec le premier trou traversant.

11. Appareil électronique selon la revendication 5, comprenant en outre :
une fenêtre de caméra (360) conçue pour recouvrir au moins partiellement le module de caméra, ladite fenêtre de caméra étant disposée sur la deuxième surface de l'élément décoratif de caméra.

12. Appareil électronique selon la revendication 11, dans lequel la fenêtre de caméra comporte un trou de microphone (361) à travers lequel le son est introduit depuis l'extérieur du boîtier, le trou de microphone étant au moins partiellement en communication fluidique avec le premier trou traversant.

13. Appareil électronique selon la revendication 12, dans lequel l'élément décoratif de caméra comprend une partie saillante (323) conçue pour s'étendre depuis au moins une zone partielle de la deuxième surface vers l'extérieur du boîtier de telle manière qu'au moins une partie de l'élément décoratif de caméra fait saillie vers l'extérieur du boîtier, et
dans lequel la partie saillante comporte un troisième trou traversant (326) permettant une communication fluidique avec le trou de microphone et le premier trou traversant.

14. Appareil électronique selon la revendication 1, comprenant en outre :
une deuxième carte de circuit imprimé (250) disposée à l'intérieur du boîtier et conçue de telle manière qu'au moins une partie en chevauche la première carte de circuit imprimé, vu depuis le dessus de la première carte de circuit imprimé, et
au moins un élément de connexion (252) disposé entre la deuxième carte de circuit imprimé et la première carte de circuit imprimé,
l'élément de connexion connectant électriquement la deuxième carte de circuit imprimé et la première carte de circuit imprimé.
